# EUROPEAN PATENT SPECIFICATION

(11) **EP 0 851 442 B1**
(45) Date of publication and mention of the grant of the patent: **04.02.2004**
(21) Application number: 97660151.8
(22) Date of filing: 19.12.1997
(51) Int. Cl.: H01F 38/36, G01R 15/14, G01R 15/18

(54) **Lead-in insulator**
Isolator für Stromzuführung
Isolateur d'amenée de courant

(30) Priority: 31.12.1996 FI 965298
(43) Date of publication of application: 01.07.1998
(73) Proprietor: ABB Technology AG, 8050 Zürich (CH)
(72) Inventor: Rautiainen, Kari, 65100 Vaasa (FI); Mähönen, Pentti, 65320 Vaasa (FI); Virtanen, Vesa, 65320 Vaasa (FI); Jokinen, Jorma, 66440 Tervajoki (FI)
(74) Representative: Peltonen, Antti Sakari

(56) References cited:
- EP-A- 0 510 426
- DE-A- 3 544 508
- DE-A- 4 435 864
- DE-U- 29 605 845
- US-A- 5 432 438

## Description

### FIELD OF THE INVENTION

The present invention relates to a lead-in insulator comprising a body and a primary conductor centrally led through the body of the insulator, a current measuring element arranged around the primary conductor, and a first voltage measuring element, based on voltage division and arranged inside the current measuring element concentrically with the current measuring element.

The space utilization of medium voltage apparatuses has been enhanced lately by replacing conventional current and voltage transformers with sensor assemblies. Space saving can be further enhanced by integrating sensors into different rail and cable mounting elements, such as a resistive voltage divider into a rail pin insulator or a current measuring sensor into a cable lead-in insulator.

Lead-in insulators according to the preamble are known e.g. from US patent publications 4,074,193 and 5,272,460. In these solutions the current and voltage measuring sensors are integrated into a nested apparatus, the current measuring sensor acting as a disturbance shield around the voltage measuring element. This provides a relatively accurate voltage measurement which at least to some extent tolerates the disturbance fields effective around the insulator. As far as apparatuses and rails are concerned it is vitally important to know if the apparatus or rail is live in order for maintenance to be carried out absolutely safely. In this respect the insulators known from the above references do not, in addition to said voltage measuring element, comprise other elements enabling voltage detection, and consequently it is not possible to achieve a sufficient reliability level with these insulators without separate devices suitable for voltage detection.

Lead-in insulators according to the preamble and further including a third element for voltage detection are known from DE-U-296 05 845 and DE-A 44 35 864.

The lead-in insulators known from the above-mentioned references have a straight body. Typically only one downward extending cable can be connected to a straight lead-in insulator. If more parallel cables are to be connected to the lead-in, the apparatuses and rails have to be subjected to a structurally expensive arrangement by means of which the lead-in insulator can be positioned horizontally. Several downwards extending parallel cables can then be connected to such a horizontal lead-in insulator by means of T-branch cable terminals.

### SUMMARY OF THE INVENTION

It is the object of the present invention to provide a lead-in insulator in which a rail pin insulator, a cable terminal, and several measuring sensors are functionally connected in order to enable several cables to be connected to the lead-in insulator without costly structural solutions.

In order to achieve the above object the lead-in insulator of the invention is primarily characterized in that the lead-in insulator further comprises a second voltage measuring element for voltage detection, disposed around the primary conductor and arranged axially displaced along the primary conductor with respect to said first voltage measuring element.

Several electrotechnical and structural advantages are achieved by the invention since the voltage measuring element of the insulator is disposed concentrically inside the current measuring element. The most substantial structural advantage is that the current and voltage measuring elements require only a short axial space, whereby the body of the lead-in insulator and consequently the therein centrally traversing primary conductor can be bent into a desired angle, preferably an angle of substantially 90°, although the insulator is further provided with a voltage detection element, disposed axially with respect to the voltage measuring element. Because of the bending into an angle, several parallel cables can be coupled to the cable terminal by the use of T-branch cable terminals without having to place the lead-in insulator in a horizontal position.

The basic idea of the insulator of the invention is that the separation of voltage measuring from voltage detection ensures that a fault in the voltage measuring circuit does not result in an incorrect diagnosis regarding the presence of voltage. The lead-in insulator of the invention enables the use of two such voltage measuring sensors, typically metal cylinders, since the current and voltage measuring sensors are nested.

It is also possible to avoid the effects of external disturbances on the measuring elements by means of the structure by surrounding the coil of the Rogowski sensor with a metal casing on whose inner periphery is arranged a circling breakpoint or gap opposite the metal cylinder employed as the voltage measuring element.

In the lead-in insulator of the invention, the nested disposition of the current measuring and voltage measuring elements may also be utilized electrotechnically such that the metal casing of the Rogowski sensor acting as the current measuring element, coupled to the ground potential, operates as the ground plane of the capacitive voltage measuring sensor.

### LIST OF DRAWINGS

In the following the lead-in insulator of the invention will be described in more detail with reference to the attached drawing, in which
Figure 1 shows the general structure of the lead-in insulator of the invention,
Figure 2 shows a more detailed structure of the current and voltage measuring elements comprised by the lead-in insulator of Figure 1, and
Figure 3 shows the electric coupling of the voltage measuring element of Figure 2.

### DETAILED DESCRIPTION OF THE INVENTION

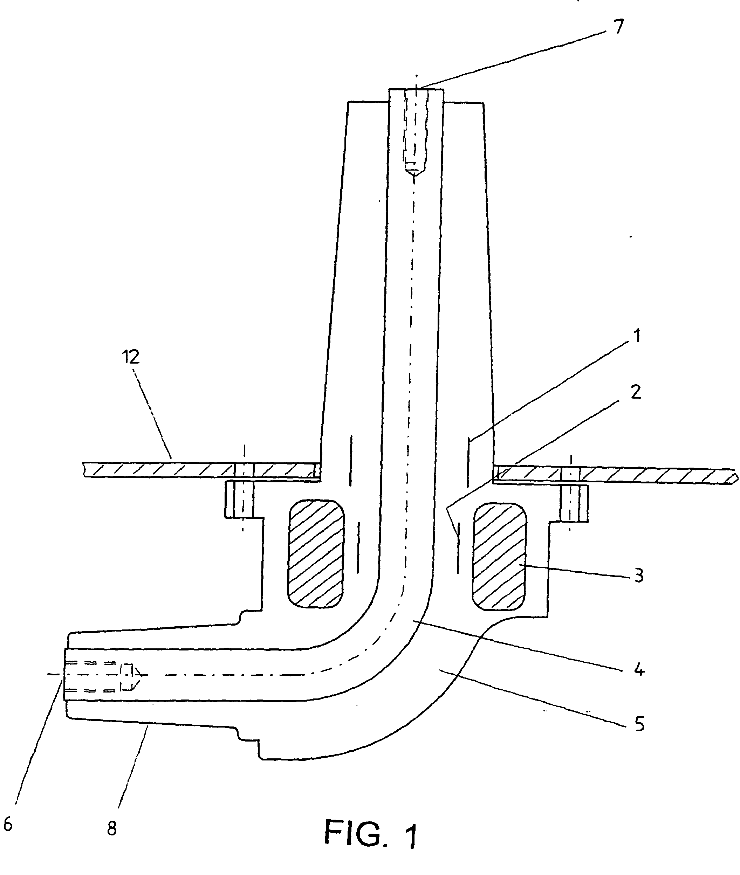

Figure 1 shows a lead-in insulator of the invention to be mounted in an opening in a wall 12 of a medium voltage apparatus. The lead-in insulator comprises a body 5 of insulating material and a primary conductor 4 running centrally inside it. The ends of the primary conductor are provided with spiral bores 6 and 7 for connections to a cable and a conductor rail, respectively. For connecting to a cable, the insulator comprises a cable terminal 8 of the type of an external cone to which the T-branch cable terminal at the end of the cable is secured. As has been disclosed above, a plurality of such T-branch cable terminals can be connected in parallel, allowing several cables to be connected by means of the same lead-in.

As the Figure clearly shows, the body 5 of the lead-in insulator and the primary conductor 4 arranged therein form a substantially 90° angle to enable T-branch cable terminals of the type described above to be used in a lead-in insulator without having to place it in a horizontal position. Thus the lead-in insulator of the invention allows the use of conventional apparatus and rail structures, a possibility which does not exist when the lead-in insulator is disposed in a horizontal position. Consequently, the use of the lead-in insulator of the invention enables significantly simpler apparatus structures compared with other solutions enabling the connection of several cables to the same lead-in insulator.

As Figure 1 shows, three sensors are arranged inside the lead-in insulator of the invention, reference numeral 1 denoting a metal cylinder employed for voltage detection, reference numeral 2 denoting a metal cylinder employed for voltage measuring, and reference numeral 3 denoting a Rogowski sensor employed for current measuring. It is essential in the lead-in insulator of the invention that the metal cylinder 2 for voltage measuring and the Rogowski sensor 3 are nested. This reduces the axial length of the lead-in insulator enabling it to be turned into a 90° angle and also providing several electrotechnical advantages to the operation of the sensors.

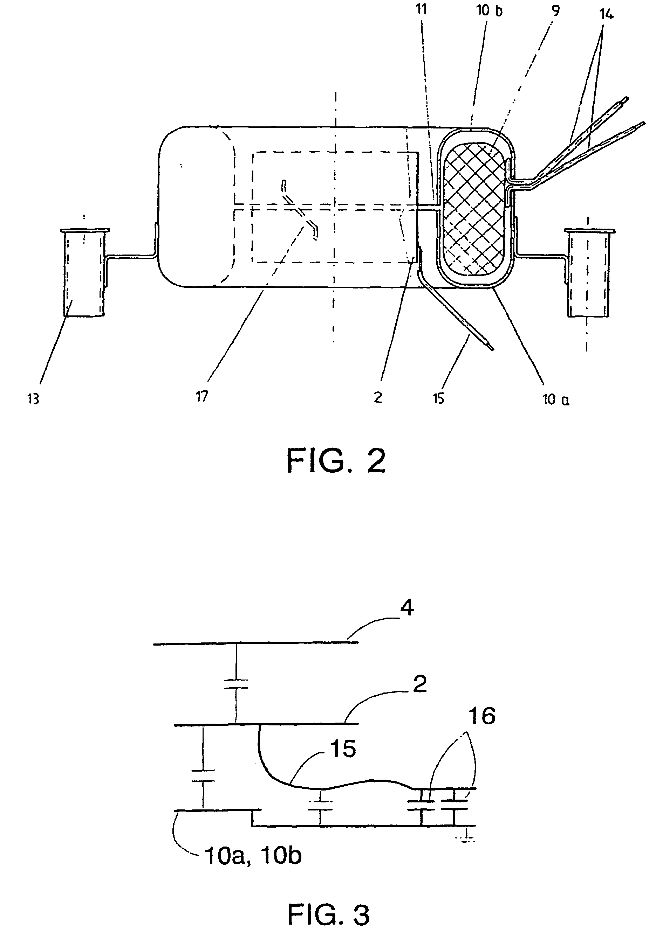

Figure 2 shows in more detail the structures of the Rogowski sensor 3 and the metal cylinder 2 arranged therein and serving as the voltage measuring element. The Rogowski sensor comprises a toroidal coil 9 around which is arranged a metal casing made of two halves 10a and 10b that can be partially nested. The electrical coupling of the halves is secured by a copper conductor 17. Since the cross section of the metal case of the Rogowski sensor must not form a closed loop, the halves 10a and 10b are separated from one another by an air gap 11 which in a finished lead-in insulator is filled with the insulating material of the lead-in insulator, such as cast resin. This gap 11 forms a gap circulating around the inner periphery of the toroidal ring formed by the halves 10a and 10b and opposite which the metal cylinder 2 employed as the voltage measuring element is disposed. The purpose of placing the air gap of the toroidal metal casing of the Rogowski sensor on the inner periphery of the casing assembly is to avoid external disturbances.

Mounting bushings 13 are also connected to the casing half 10a of the Rogowski sensor and serve to couple the entire lead-in insulator to the mounting opening in the wall 12 of the apparatus. These bushings also serve to ground the metal sheath of the Rogowski sensor. Reference numerals 14 denote coupling conductors to the coil 9 of the Rogowski sensor. The metal cylinder 2 serving as the voltage measuring element and based on capacitive voltage division is embodied in the Rogowski sensor. The metal case of the Rogowski sensor is coupled to the ground potential through mounting brackets 13 and serves as the ground plane for the capacitive voltage measuring sensor 2, whereby there is no need for a separate ground plane typical of a capacitive voltage measuring element. When grounded, the metal case 10a, 10b of the Rogowski sensor attenuates the disturbances caused in voltage measuring by external electric fields.

Figure 3 illustrates the electric coupling of the voltage measuring element 2, and, for the sake of clarity, the same reference numerals as in Figures 1 and 2 designate the different components of the measuring arrangement. Figure 3 shows how a capacitive coupling is formed between the primary conductor and the metal cylinder 2 and between the voltage measuring cylinder 2 and the casing 10a, 10b of the Rogowski sensor. Like in Figure 2, in the coupling of Figure 3 the measuring conductor connected to the voltage measuring element 2 is denoted by the reference numeral 15. This conductor is a coaxial cable with a grounded sheath, as is apparent from the coupling of Figure 3. Figure 3 further shows external capacitances 16, forming part of the capacitive measuring arrangement of the voltage measuring element.

In addition to the metal case of the Rogowski sensor being used as the ground plane for the voltage measuring element, the metal cylinder 2 of the voltage measuring sensor also provides an advantage in the operation of the Rogowski sensor by preventing the effect of the electric field of the primary conductor 4 directly on the coil 9 of the Rogowski sensor through the air gap 11 in its metal casing 10a, 10b.

As has been stated above and as is apparent from Figure 1, a second separate metal cylinder 1 is also disposed for voltage detection around the primary conductor 4. The separation of voltage measuring and detection ensures that a fault in the voltage measuring circuit does not cause an erroneous diagnosis regarding the presence of voltage.

In the sensor arrangement comprised by the lead-in insulator of the invention, the magnitude and stability of the capacitance generated between the primary conductor 4 and the metal cylinder 2 of the voltage measuring element and between the metal cylinder 2 and the metal casing serving as the ground plane depend on the material used as insulant. As regards production costs, the most inexpensive method is to cast the voltage measuring element 2 into the same cast resin as the rest of the structure, but it is possible to cast the measuring elements 2 and 3 first into a different material which is then cast inside normal cast resin in order to produce the lead-in insulator assembly of the invention.

In the above the lead-in insulator of the invention has been described only by means of an exemplary embodiment and it is to be understood that several details can be modified without, however, departing from the scope of protection defined by the attached claims.

## Claims

1. A lead-in insulator comprising a body (5) and a primary conductor (4) centrally led through the body (5) of the insulator, a current measuring element (3) arranged around the primary conductor, and a first voltage measuring element (2), based on voltage division and arranged inside the current measuring element (3) concentrically with the current measuring element (3), **characterized in that** the lead-in insulator further comprises a second voltage measuring element (1) for voltage detection disposed around the primary conductor (4) and arranged axially displaced along the primary conductor (4) with respect to said first voltage measuring element (2).

2. A lead-in insulator as claimed in claim 1, **characterized in that** the primary conductor (4) is bent into an angle, preferably an angle of substantially 90°.

3. A lead-in insulator as claimed in claim 1 or 2 when the current measuring element is a Rogowski sensor (3) comprising a toroidal coil (9), **characterized in that** the coil (9) of the Rogowski sensor is surrounded by a toroidal metal case (10a, 10b) comprising a breakpoint or gap (11) circulating around an inner periphery of said case, said breakpoint or gap being opposite a metal cylinder (2) employed as said first voltage measuring element.

4. A lead-in insulator as claimed in claim 3, **characterized in that** the metal case (10a, 10b) of the Rogowski sensor (3) is coupled to ground potential and serves as the ground plane for said voltage measuring element (2).

## Patentansprüche

1. Isolator für Stromzuführung, der einen Körper (5) und einen zentral durch den Körper (5) des Isolators geführten Hauptleiter (4), ein um den Hauptleiter angeordnetes Strommesselement (3) und ein erstes Spannungsmesselement (2) aufweist, welches auf Spannungsteilung beruht und innerhalb des Strommesselements (3) konzentrisch mit dem Strommesselement (3) angeordnet ist, **dadurch gekennzeichnet, dass** der Einführungsisolator zudem ein zweites Spannungsmesselement (1) zum Spannungsnachweis aufweist, welches um den Hauptleiter (4) angeordnet und axial versetzt entlang dem Hauptleiter (4) in Bezug auf das genannte erste Spannungsmesselement (2) angeordnet ist.

2. Isolator für Stromzuführung, wie in Anspruch 1 beansprucht, **dadurch gekennzeichnet, dass** der Hauptleiter (4) um einen Winkel, vorzugsweise einen Winkel von im Wesentlichen 90°, gebogen ist.

3. Isolator für Stromzuführung, wie in Anspruch 1 oder 2 beansprucht, der, wenn das Strommesselement ein Rogowski-Sensor (3) mit einer ringförmigen Spule (9) ist, **dadurch gekennzeichnet ist, dass** die Spule (9) des Rogowski-Sensors von einem ringförmigen Metallgehäuse (10a, 10b) umgeben ist, das einen Durchbruch oder Spalt (11) aufweist, welcher um einen Innenumfang des genannten Gehäuses umläuft, wobei der genannte Durchbruch oder Spalt gegenüber einem als oben genanntes erstes Spannungsmesselement benutzten Metallzylinder (2) ist.

4. Isolator für Stromzuführung, wie in Anspruch 3 beansprucht, **dadurch gekennzeichnet, dass** das Metallgehäuse (10a, 10b) des Rogowski-Sensors (3) an das Masse-Potential gekoppelt ist und als Masse-Platte für das genannte Spannungsmesselement (2) dient.

## Revendications

1. Isolateur de traversée comprenant un corps (5) et un conducteur primaire (4) passant au centre du corps (5) de l'isolateur , un élément de mesure d'intensité (3) disposé autour du conducteur primaire, et un premier élément de mesure de tension (2), fonctionnant par division de tension et disposé à l'intérieur de l'élément de mesure d'intensité (3), de manière concentrique à l'élément de mesure d'intensité (3), **caractérisé en ce que** l'isolateur de traversée comprend en outre un second élément de mesure de tension (1) servant à détecter la tension, disposé autour du conducteur primaire (4) et décalé axialement le long du conducteur primaire (4) par rapport audit premier élément de mesure de tension (2).

2. Isolateur de traversée selon la revendication 1, **caractérisé en ce que** le conducteur primaire (4) est coudé suivant un angle, de préférence un angle sensiblement de 90°.

3. Isolateur de traversée selon la revendication 1 ou 2, l'élément de mesure d'intensité étant un capteur de Rogowski comprenant une bobine toroïdale (9), **caractérisé en ce que** la bobine (9) du capteur de Rogowski est entourée par une enveloppe métallique toroïdale (10a), (10b) comportant un point d'interruption ou un entrefer (11) s'étendant sur le pourtour intérieur de ladite enveloppe, ledit point d'interruption ou entrefer étant en regard d'un cylindre métallique (2) servant de premier élément de mesure de tension.

4. Isolateur de traversée selon la revendication 3, **caractérisé en ce que** l'enveloppé métallique (10a), (10b) du capteur de Rogowski (3) est mise à la masse et sert de plan de masse pour ledit élément de mesure de tension (2).
